# EUROPEAN PATENT SPECIFICATION

(11) **EP 3 646 039 B1**
(45) Date of publication and mention of the grant of the patent: **10.08.2022**
(21) Application number: 17736905.5
(22) Date of filing: 29.06.2017
(51) Int. Cl.: G01R 31/64, G01R 19/165

(54) **CAPACITOR OR CAPACITIVE SENSOR CHECKING**
PRÜFEN EINES KONDENSATORS ODER KAPAZITIVEN SENSORS
VÉRIFICATION DE CONDENSATEUR OU DE CAPTEUR CAPACITIF

(43) Date of publication of application: 06.05.2020
(73) Proprietor: Robert Bosch GmbH, 70442 Stuttgart (DE)
(72) Inventor: DHUA, Suman, 73525 Schwäbisch Gmünd (DE)
(86) International application number: PCT/EP2017/066159
(87) International publication number: WO 2019/001716

(56) References cited:
- WO-A1-2017/137128
- US-A- 5 880 589
- US-A1- 2006 164 102
- US-A1- 2010 295 554
- US-A1- 2014 320 155

## Description

### AREA OF INVENTION

The invention at hand is concerned to a method for checking a capacitor or a capacitive sensor of a steering system.

### BACKGROUND OF THE INVENTION

As state of the art it is already well-known to use capacitors and capacitive sensors for steering systems.

US 2014/320155 A1 discloses an electronic circuit having a fault detection circuit and US2006/164102 A1 discloses an electronic circuit for short circuit monitoring.

### SUMMARY OF THE INVENTION

A steering system comprises a huge amount of capacitors and capacitive sensors.

Even the malfunction of one single capacitor can lead to failure of the whole system.

Therefore, a task is to prevent malfunction of a steering system because of the failure of a capacitor or a capacitive sensor.

In the invention , being defined by the features of claim 1, it is provided a method for checking a capacitor or a capacitive sensor of a steering system, comprising the steps: charging the capacitor or the capacitive sensor, Measuring the voltage line of charging and/or discharging and Evaluating the voltage line.

It is also possible to apply the method for the discharging process.

Exemplary applications will be described as follows:
According to an exemplary embodiment of the invention it is provided a method, comprising the step: Evaluating the voltage line, wherein a low and a high threshold is applied.

By using only two thresholds for the method, it is very easy to apply the method.

According to an exemplary embodiment of the invention it is further provided a method, comprising the additional step: if the voltage line is increasing during the charging period, then the capacitor or capacitive sensor is ready for operation.

It is also possible to use the discharging voltage line for applying the method.

According to an exemplary embodiment of the invention it is more further provided a method, comprising the additional step: If the voltage line is nearly equal to the low threshold, then the capacitor or the capacitive sensor is shorted and not ready for operation.

According to an exemplary embodiment of the invention it is provided a method, comprising the additional step: if the voltage line is nearly equal to the high threshold, then the capacitor or the capacitive sensor is opened and not ready for operation.

According to an exemplary embodiment variant of the invention it is further provided a method, wherein the low threshold is between 0 Volt to 2 Volt, especially 0 Volt to 1 Volt.

The thresholds depend upon the tolerance of supply voltage and used resistors.

Therefore, these values are only typical examples, which can differ depending on the special electrical situation.

According to an exemplary embodiment of the invention it is more further provided a method, wherein the high threshold is between 3 Volt to 5 Volt, especially 4 Volt to 5 Volt or 10 Volt to 12 Volt, especially 11 Volt to 12 Volt or 2 Volt to 3 Volt, especially 2.5 Volt to 3 Volt.

According to the invention it is provided a method, wherein there are 1, 2, 3, 4, 5, 6, 7 or more voltage samples, comprising the step: If the majority of the samples determine the capacitor or capacitive sensor as open, it is assumed, that the capacitor or capacitive sensor is open and if the majority of the samples determine the capacitor or capacitive sensor as short, it is assumed, that the capacitor or capacitive sensor is short and if the majority of the samples determine the capacitor or capacitive sensor as ready for operation, it is assumed, that the capacitor or capacitive sensor is ready for operation.

The samples can be read by an ADC (Analog Digital Converter). When the capacitor or capacitive sensor is charged for the time t_{ON}, ADC read the capacitor or capacitive sensor charging voltage in different time intervals, e.g. t1, t2, t3... (within t_{ON} time). ADC reads the capacitor or capacitive sensor charging voltage for those time intervals (samples) to determine the voltage line behavior like "short", "open" or "normal".

According to an exemplary embodiment of the invention it is further provided a method, wherein the number of samples is odd, especially 3, 5 or 7.

According to an exemplary embodiment of the invention it is more further provided a method, wherein a capacitive sensor is under check, wherein the sample is taken during a time period of not working and/or wherein the steps are executed before starting the steering system.

The term "not working" means especially that the system, to which the capacitive sensor belongs, is not in normal operation mode.

As an idea of the invention it can be regarded to provide a method for detecting the malfunction of a capacitor or a capacitive sensor of a steering system by charging and discharging the capacitor or capacitive sensor concerned. The load currents, which were charged and discharged will be evaluated. In case the load current, which was charged is small, there is an open circuit. In case the load current, which was charged is high and the load current, which was discharged is small, there is a short-circuit. Otherwise, the capacitor or capacitive sensor is ready to work. The idea can be summarized as a diagnostics of the charging/discharging performance of a capacitor or a capacitive sensor under control, wherein the charging/discharging voltage will be applied for a short time and the same charging/discharging voltage is read by an ADC (analog digital converter). The diagnostics is applied usually before the whole system starts to work in normal mode in order to avoid a failure mode of the steering system concerned. A failure mode of the device under control can be identified if a short circuit or an open circuit can be detected. A failure mode of the device can also be identified in normal operation for short time without disturbing system normal operation.

### SHORT SPECIFICATION OF THE DRAWINGS

Further details will be described with the help of the following figures, wherein the figures describe:
Fig. 1 a capacitor diagnostics circuit diagram,
Fig. 2 a capacitor diagnostics timing sequence,
Fig. 3 a capacitance sensor diagnostics circuit diagram,
Fig. 4 a diagnostic timing sequence,
Fig. 5 a flow chart and
Fig. 6 a further flow chart.

### DETAILED DESCRIPTION OF EXEMPLARY EMBODIMENTS

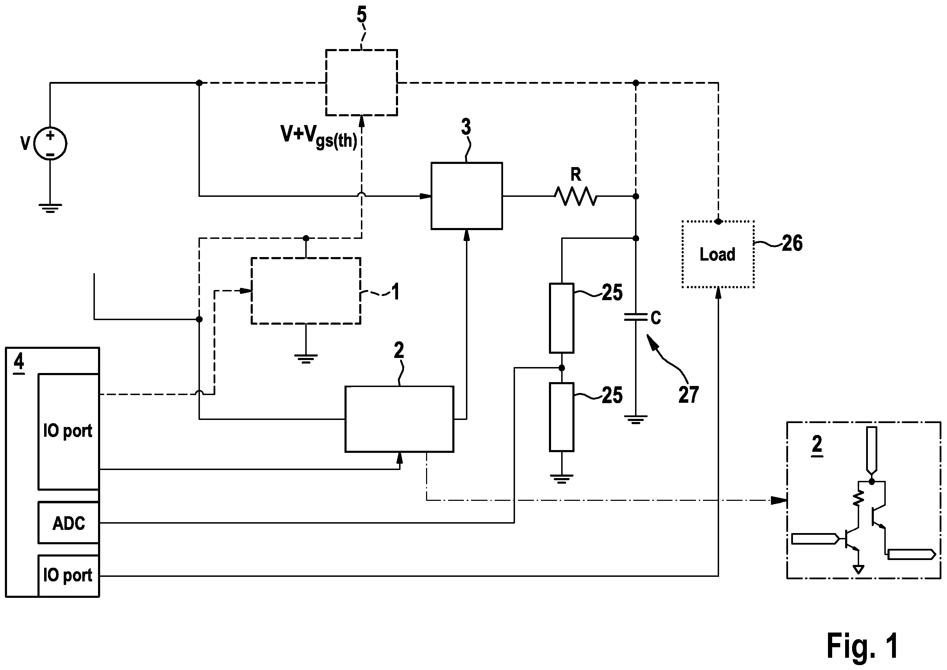

Fig. 1 depicts a transistor resistor topology #1 1 and a transistor resistor topology #2 2 with two transistors and one resistor and a mosfet #2 3, a microcontroller 4 and a mosfet #1 5. Fig. 1 shows a circuit, which applies a diagnostics strategy for a capacitor as follows: capacitor C 27 is used as a buffer capacitor, Mosfet #1 5 is in series, for example for reverse polarity protection, which is usually on switched. The capacitor C 27 is under observation. The resistor R is used to charge the capacitor C 27 for short time (t_{ON}) and microcontroller 4 is applied as control unit for the mosfet #1 5. The resistors 25 are used as resistor divider to transform the voltage of the load 26 into readable values for the ADC of the microcontroller 4. The circuit can be used to apply a diagnostics strategy for capacitors as follows, wherein it is preferred to apply the strategy before the system starts with normal operation mode. At first mosfet #1 5 is off-switched and mosfet #2 is on-switched to charge the capacitor C 27 for a time t_{ON}. Next, the load is switched off to avoid load inductance property in charging.

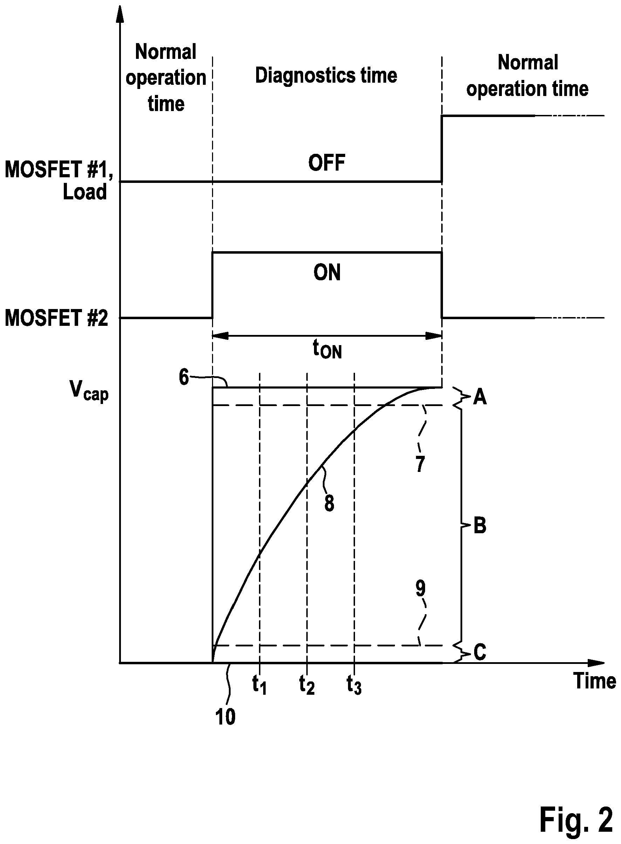

Fig. 2 shows a voltage line 6, if the capacitor is opened, a voltage line 8, if the capacitor is normal and a voltage line 10, if the capacitor under surveillance is short.

The lines 7 and 9 define thresholds. Therefore, the area A illustrates the region, which shows, that the capacitor or the capacitive sensor under observation is opened. The region C depicts the area, which stands for a shorted capacitor or shorted capacitive sensor. The area B reflects the region, where the voltage line for a normal capacitor or capacitive sensor should be.

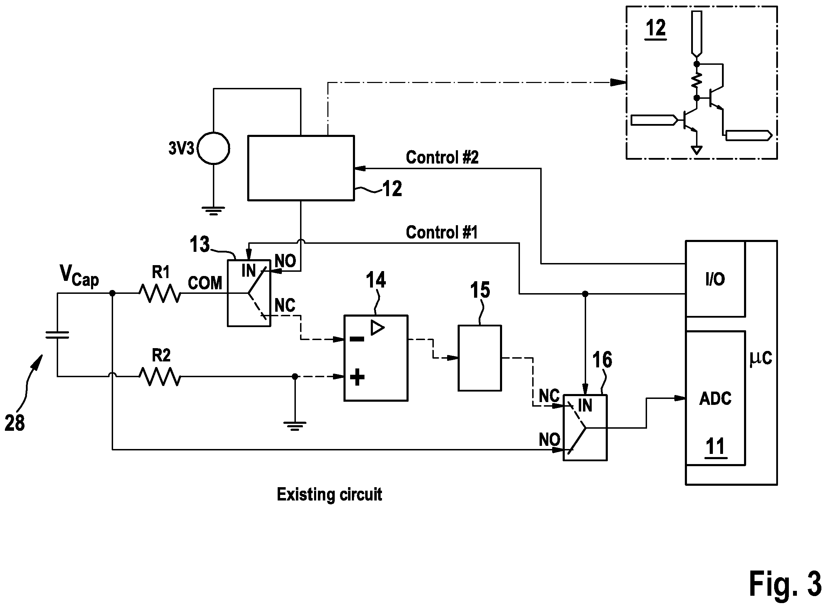

Fig. 3 shows an Analog Digital Converter 11, a transistor topology 12, an analog switch #1 13, an amplifier 14, a filter 15 and an analog switch #2 16. The capacitive sensor 28 is under observation.

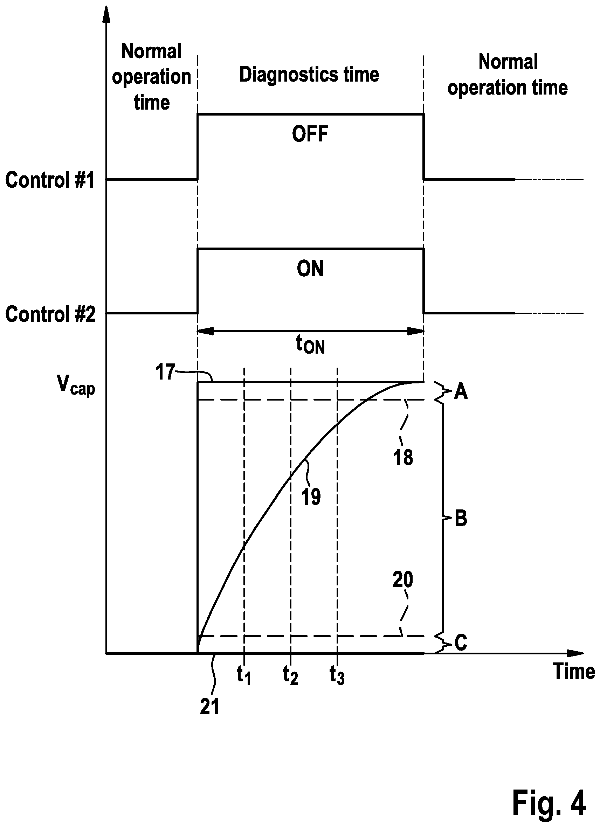

Fig. 4 shows a voltage line 17 if capacitance sensor is opened, a voltage line 19 if capacitance sensor is normal, a voltage line 21, if capacitance sensor is short and lines 18 and 20, which represent thresholds. Therefore, the area A illustrates the region, which shows, that the capacitor or the capacitive sensor under observation is opened. The region C depicts the area, which stands for a shorted capacitor or shorted capacitive sensor. The area B reflects the region, where the voltage line for a normal capacitor or capacitive sensor should be.

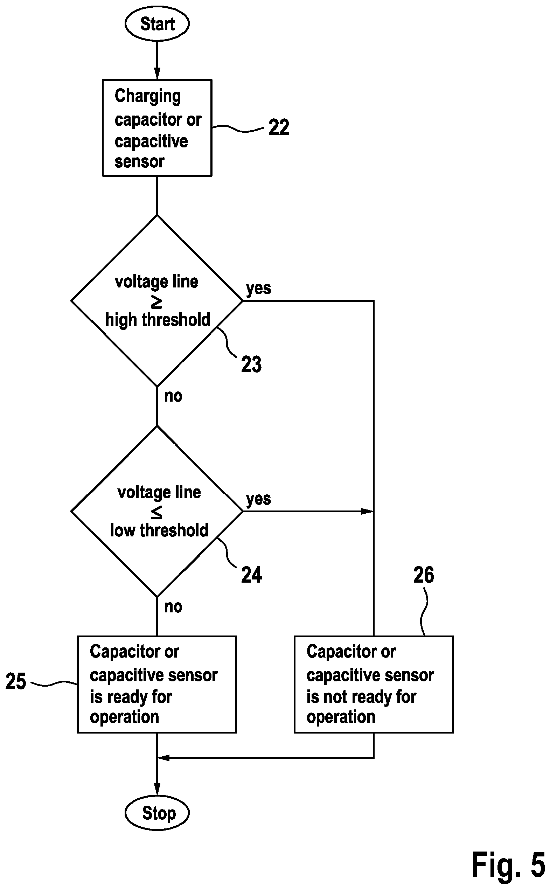

Fig. 5 shows a tlow chart of a method not falling under the present invention but useful for the understanding thereof, wherein at first a capacitor or a capacitive sensor is charged 22. If the resulting voltage line is a high threshold or higher 23 then the capacitor is not ready for operation 26. If the voltage line is a low threshold or underneath 24 then the capacitor is also not ready for operation 26.

Otherwise the capacitor or capacitive sensor is ready for operation 25.

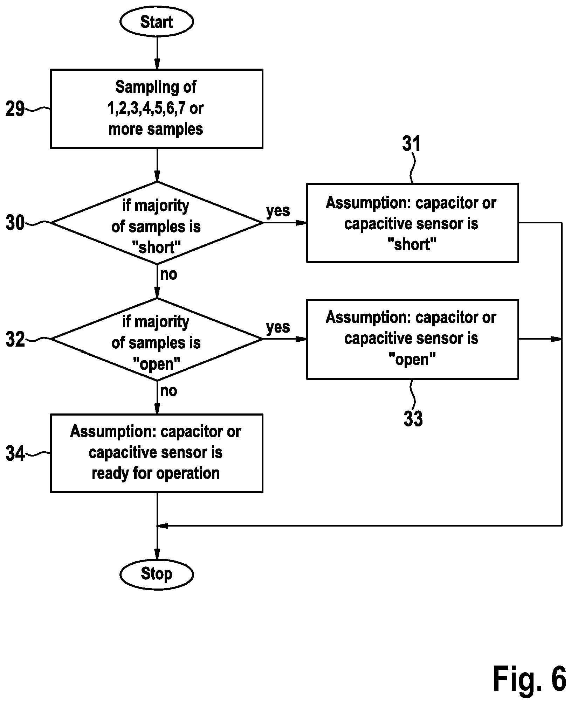

Fig. 6 shows a method, wherein there are 1, 2, 3, 4, 5, 6, 7 or more samples 29, comprising the step: if the majority of the samples determine the capacitor or capacitive sensor as open 32, it is assumed, that the capacitor or capacitive sensor is open 33 and If the majority of the samples determine the capacitor or capacitive sensor as short 30, it is assumed, that the capacitor or capacitive sensor is short 31 and If the majority of the samples determine the capacitor or capacitive sensor as ready for operation, it is assumed, that the capacitor or capacitive sensor is ready for operation. The number of samples can be odd, especially 3, 5 or 7. The samples can be taken during a time period of not working, especially a period of no normal operation mode, and/or wherein the steps are executed before starting the steering system.

## Claims

1. Method for checking a capacitor (27) or a capacitive sensor (28) of a steering system, comprising the steps:
Charging the capacitor (27) or the capacitive sensor (28),
Measuring the voltage line (6, 8, 10, 17, 19, 21) of charging and/or
discharging and
Evaluating the voltage line (6, 8, 10, 17, 19, 21),
wherein there are 1, 2, 3, 4, 5, 6, 7 or more voltage samples ,**characterised in that** the evaluation of the voltage line (6, 8, 10, 17, 19, 21) comprises the step:
If the majority of the voltage samples determine the capacitor (27) or capacitive sensor (28) as open, it is assumed, that the capacitor (27) or capacitive sensor (28) is open and
If the majority of the voltage samples determine the capacitor (27) or capacitive sensor (28) as short, it is assumed, that the capacitor (27) or capacitive sensor (28) is short and
If the majority of the voltage samples determine the capacitor (27) or capacitive sensor (28) as ready for operation, it is assumed, that the capacitor (27) or capacitive sensor (28) is ready for operation.

2. Method according to claim 1, comprising the step:
Evaluating the voltage line (6, 8, 10, 17, 19, 21), wherein a low and a high voltage threshold (7, 9, 18, 20) is applied.

3. Method according to claim 2 comprising the additional step:
If the voltage line's voltage is increasing during the charging period, then the capacitor (27) or capacitive sensor (28) is determined to be ready for operation.

4. Method according to one of the preceding claims 2 or 3 comprising the additional step:
If the voltage line's voltage is equal to the low voltage threshold (9, 20), then the capacitor (27) or the capacitive sensor (28) is determined to be shorted and not ready for operation.

5. Method according to one of the preceding claims 2 to 4 comprising the additional step:
If the voltage line's voltage is equal to the high voltage threshold (7, 18), then the capacitor (27) or the capacitive sensor (28) is determined to be opened and not ready for operation.

6. Method according to any one of the claims 2 to 5, wherein the low voltage threshold (9, 20) is between 0 Volt to 2 Volt, especially 0 Volt to 1 Volt.

7. Method according to any one of the claims 2 to 6, wherein the high voltage threshold (7, 18) is between 3 Volt to 5 Volt, especially 4 Volt to 5 Volt, or 10 Volt to 12 Volt, especially 11 Volt to 12 Volt, or 2 Volt to 3 Volt, especially 2.5 Volt to 3 Volt.

8. Method according to one of the preceding claims, wherein the number of voltage samples is odd, especially 3, 5 or 7.

9. Method according to one of the preceding claims, wherein the capacitive sensor (28) is under check, wherein the voltage sample is taken or the voltage samples are taken during a time period during which the steering system is not in normal operation mode.

10. Method according to one of the preceding claims, wherein the steps are executed before starting the steering system and/or before the steering system starts to work in normal operation mode in order to avoid a failure mode of the steering system.

## Patentansprüche

1. Verfahren zur Prüfung eines Kondensators (27) oder eines kapazitiven Sensors (28) eines Lenksystems, umfassend die folgenden Schritte:
Laden des Kondensators (27) oder des kapazitiven Sensors (28),
Messen der Spannungslinie (6, 8, 10, 17, 19, 21) zum Laden und/oder Entladen und
Bewerten der Spannungslinie (6, 8, 10, 17, 19, 21), wobei es 1, 2, 3, 4, 5, 6, 7 oder mehr Spannungsproben gibt, **dadurch gekennzeichnet, dass** die Bewertung der Spannungslinie (6, 8, 10, 17, 19, 21) den folgenden Schritt umfasst:
wenn die Mehrheit der Spannungsproben den Kondensator (27) oder den kapazitiven Sensor (28) als offen bestimmt, wird angenommen, dass der Kondensator (27) oder der kapazitive Sensor (28) offen ist, und
wenn die Mehrheit der Spannungsproben den Kondensator (27) oder den kapazitiven Sensor (28) als kurzgeschlossen bestimmt, wird angenommen, dass der Kondensator (27) oder der kapazitive Sensor (28) kurzgeschlossen ist, und
wenn die Mehrheit der Spannungsproben den Kondensator (27) oder den kapazitiven Sensor (28) als betriebsbereit bestimmt, wird angenommen, dass der Kondensator (27) oder der kapazitive Sensor (28) betriebsbereit ist.

2. Verfahren nach Anspruch 1, umfassend den folgenden Schritt:
Bewerten der Spannungslinie (6, 8, 10, 17, 19, 21), wobei eine untere und eine obere Spannungsschwelle (7, 9, 18, 20) angelegt wird.

3. Verfahren nach Anspruch 2, umfassend den folgenden zusätzlichen Schritt:
wenn die Spannung der Spannungslinie während des Ladezeitraums zunimmt, dann wird bestimmt, dass der Kondensator (27) oder der kapazitive Sensor (28) betriebsbereit ist.

4. Verfahren nach einem der Ansprüche 2 oder 3, umfassend den folgenden zusätzlichen Schritt:
wenn die Spannung der Spannungslinie gleich der unteren Spannungsschwelle (9, 20) ist, dann wird bestimmt, dass der Kondensator (27) oder der kapazitive Sensor (28) kurzgeschlossen und nicht betriebsbereit ist.

5. Verfahren nach einem der Ansprüche 2 bis 4, umfassend den folgenden zusätzlichen Schritt:
wenn die Spannung der Spannungslinie gleich der oberen Spannungsschwelle (7, 18) ist, dann wird bestimmt, dass der Kondensator (27) oder der kapazitive Sensor (28) geöffnet und nicht betriebsbereit ist.

6. Verfahren nach einem der Ansprüche 2 bis 5, wobei die untere Spannungsschwelle (9, 20) zwischen 0 Volt und 2 Volt, insbesondere 0 Volt und 1 Volt liegt.

7. Verfahren nach einem der Ansprüche 2 bis 6, wobei die obere Spannungsschwelle (7, 18) zwischen 3 Volt und 5 Volt, insbesondere 4 Volt und 5 Volt, oder 10 Volt und 12 Volt, insbesondere 11 Volt und 12 Volt, oder 2 Volt und 3 Volt, insbesondere 2,5 Volt und 3 Volt liegt.

8. Verfahren nach einem der vorhergehenden Ansprüche, wobei die Anzahl von Spannungsproben ungerade, insbesondere 3, 5 oder 7 ist.

9. Verfahren nach einem der vorhergehenden Ansprüche, wobei der kapazitive Sensor (28) einer Prüfung unterzogen wird, wobei die Spannungsprobe genommen wird oder die Spannungsproben während eines Zeitraums genommen werden, während dessen das Lenksystem sich nicht im Normalbetriebsmodus befindet.

10. Verfahren nach einem der vorhergehenden Ansprüche, wobei die Schritte ausgeführt werden, bevor das Lenksystem gestartet wird und/oder bevor das Lenksystem im Normalbetriebsmodus zu funktionieren beginnt, um einen Ausfallmodus des Lenksystems zu vermeiden.

## Revendications

1. Procédé de contrôle d'un condensateur (27) ou d'un capteur capacitif (28) d'un système de direction, comprenant les étapes suivantes :
charger le condensateur (27) ou le capteur capacitif (28),
mesurer la ligne de tension (6, 8, 10, 17, 19, 21) de la charge et/ou de la décharge et
évaluer la ligne de tension (6, 8, 10, 17, 19, 21) ,
dans lequel il y a 1, 2, 3, 4, 5, 6, 7 échantillons de tension ou plus, **caractérisé en ce que** l'évaluation de la ligne de tension (6, 8, 10, 17, 19, 21) comprend l'étape suivante :
si la majorité des échantillons de tension détermine le condensateur (27) ou capteur capacitif (28) comme étant ouvert, il est supposé, que le condensateur (27) ou capteur capacitif (28) est ouvert et
si la majorité des échantillons de tension détermine le condensateur (27) ou le capteur capacitif (28) comme étant court-circuité, il est supposé, que le condensateur (27) ou le capteur capacitif (28) est court-circuité et
si la majorité des échantillons de tension détermine le condensateur (27) ou le capteur capacitif (28) comme étant prêt à fonctionner, il est supposé, que le condensateur (27) ou le capteur capacitif (28) est prêt à fonctionner.

2. Procédé selon la revendication 1, comprenant l'étape suivante :
l'évaluation de la ligne de tension (6, 8, 10, 17, 19, 21), un seuil de tension bas et un seuil de tension haut (7, 9, 18, 20) étant appliqués.

3. Procédé selon la revendication 2, comprenant l'étape additionnelle suivante :
si la tension de la ligne de tension augmente pendant la période de chargement, alors le condensateur (27) ou le capteur capacitif (28) est déterminé comme étant prêt à fonctionner.

4. Procédé selon l'une des revendications précédentes 2 ou 3, comprenant l'étape additionnelle suivante :
si la tension de la ligne de tension est égale au seuil de tension bas (9, 20), alors le condensateur (27) ou le capteur capacitif (28) est déterminé comme étant court-circuité et n'étant pas prêt à fonctionner.

5. Procédé selon l'une des revendications précédentes 2 à 4 comprenant l'étape additionnelle suivante :
si la tension de la ligne de tension est égale au seuil de tension haut (7, 18), alors le condensateur (27) ou le capteur capacitif (28) est déterminé comme étant ouvert et n'étant pas prêt à fonctionner.

6. Procédé selon l'une quelconque des revendications 2 à 5, le seuil de tension bas (9, 20) étant entre 0 volt à 2 volts, plus spécifiquement 0 volt à 1 volt.

7. Procédé selon l'une quelconque des revendications 2 à 6, le seuil de tension haut (7, 18) étant entre 3 volts à 5 volts, plus spécifiquement 4 volts à 5 volts, ou 10 volts à 12 volts, plus spécifiquement 11 volts à 12 volts, ou 2 volts à 3 volts, plus spécifiquement 2,5 volts à 3 volts.

8. Procédé selon l'une des revendications précédentes, le nombre d'échantillons de tension étant impair, plus spécifiquement 3, 5 ou 7.

9. Procédé selon l'une des revendications précédentes, le capteur capacitif (28) étant sous contrôle, l'échantillon de tension étant prélevé ou les échantillons de tension étant prélevés pendant une période de temps pendant laquelle le système de direction n'est pas en mode de fonctionnement normal.

10. Procédé selon l'une des revendications précédentes, les étapes étant exécutées avant le démarrage du système de direction et/ou avant que le système de direction ne commence à fonctionner en mode de fonctionnement normal afin d'éviter un mode de défaillance du système de direction.
